(19) Europäisches Patentamt
European Patent Office
Office européen des brevets

(11) **EP 3 085 809 B1**

(12) **EUROPEAN PATENT SPECIFICATION**

(45) Date of publication and mention
of the grant of the patent:
**18.07.2018 Bulletin 2018/29**

(51) Int Cl.:
**C23C 14/34** (2006.01)  **C23C 4/18** (2006.01)
**C22F 1/16** (2006.01)  **H01J 37/34** (2006.01)

(21) Application number: **15164260.0**

(22) Date of filing: **20.04.2015**

(54) **PROCESS FOR PREPARING A TUBULAR SPUTTERING TARGET**

VERFAHREN ZUR HERSTELLUNG EINES ROHRFÖRMIGEN SPUTTERTARGETS

PROCÉDÉ DE PRÉPARATION D'UNE CIBLE DE TUBULAIRE PULVÉRISATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**26.10.2016 Bulletin 2016/43**

(73) Proprietor: **Materion Advanced Materials Germany
GmbH
63450 Hanau (DE)**

(72) Inventors:
• **Simons, Christoph
36599 Biebergemünd (DE)**

• **Schlott, Martin
63075 Offenbach (DE)**
• **Heindel, Josef
63512 Hainburg (DE)**
• **Stahr, Carl Christoph
63755 Alzenau (DE)**

(74) Representative: **Pillep, Bernhard et al
Kador & Partner PartG mbB
Corneliusstrasse 15
80469 München (DE)**

(56) References cited:
**EP-A1- 2 818 575    WO-A1-2015/004958
GB-A- 2 241 249    US-A1- 2016 126 072**

**Description**

For sputtering of large-scale substrates, such as glass for construction purposes, automotive glazing, flat-screen monitors and solar cells, tubular sputtering targets are typically used. Such tubular sputtering targets may have a length of up to 4000 mm. The sputtering material (i.e. the "active" material to be ejected from the sputtering target) is consumed to a much higher degree when using a tubular sputtering target (up to 90%) instead of a planar sputtering target (typically less than 40%).

However, due to their large dimensions (e.g. length of up to 4000 mm) and the curved geometry, it remains a challenge to prepare tubular sputtering targets by an efficient manufacturing process while maintaining the sputtering properties of the final sputtering target on a high level.

It would be desirable that a single-segment sputtering material of sufficient length can be obtained by an easy-to-perform and energy-efficient manufacturing method, and the sputtering target obtained by the manufacturing method can be operated at high sputtering power with low arcing. Arcs are high power density short circuits which have the effect of miniature explosions. When they occur on or near the surface of the target material, they can cause local melting. This material is ejected and can damage the material being processed and accumulates on other surfaces.

Typically, tubular sputtering materials of sufficient length (e.g. at least 500 mm or at least 1000 mm) are difficult to obtain by casting or powder metallurgical methods. With these manufacturing methods, two or more tubular sputtering material segments are prepared separately and then assembled together on a carrier tube, thereby obtaining a segmented sputtering material (i.e. a sputtering material having at least one circumferential gap separating the neighbouring segments).

DE 10 2009 015 638 describes a process for preparing a sputtering target wherein a tubular sputtering material is prepared by mould casting and subsequently subjected to a rolling treatment. Inner and outer diameters of the tubular sputtering material are increasing during the rolling treatment. The tubular sputtering target subjected to the rolling step is not fixed on a carrier tube. A further step would be needed for fixing the tubular sputtering material on a carrier tube.

In US 2012/0213917, a tubular sputtering target is described which comprises a carrier tube and an indium-based coating (i.e. the sputtering material) applied on the carrier tube. The sputtering target can be prepared by spraying Indium based metal or alloy on the carrier tube.

DE 36 18 949 A1 relates to a method and apparatus for the transverse rolling of seamless tube blanks, in which a seamless tube blank is rolled down over a mandrel rod lying in its longitudinal bore or is rolled onto a mandrel rod at the delivery end.

WO2015/004958 shows the manufacture of a tubular sputtering target by applying a coating of an indium alloy to a backing tube and subjecting the coating to plastic working in the thickness direction. It is an object of the present invention to prepare non-segmented sputtering targets of sufficient length for large-scale sputtering applications by an efficient manufacturing method. Preferably, the manufacturing method is easy-to-perform, quick and energy-efficient, and the sputtering target obtained from the process can be operated at a high energy input with low arcing and provides a sputtered product of high homogeneity.

The object is solved by a process according to claim 1 for preparing a tubular sputtering target, comprising

(a) providing a carrier tube,
(b) providing a metal coating on the carrier tube by applying a liquid metal phase onto the carrier tube and solidifying the liquid metal phase,
(c) applying a contact pressure to the metal coating by at least one densification tool, and moving the densification tool and the metal coating relative to each other.

In the present invention, it has been realized that a manufacturing process as defined above and described in further detail below is very efficient for preparing non-segmented sputtering targets that can be operated at a high power input with low arcing and provides a sputtered product of high homogeneity.

Furthermore, by selecting appropriate densification tools, the energy balance of the manufacturing process can be optimized while maintaining the beneficial sputtering properties mentioned above.

In step (a) of the process of the present invention, a carrier tube is provided.

As any tube, the carrier tube has an outer surface and an inner surface surrounding a hollow inner portion. The metal coating prepared in step (b) is typically applied on the outer surface of the carrier tube.

Tube-shaped supports for metal coatings (e.g. carrier tubes as a support for sputtering materials) are generally known to the skilled person.

Typically, the carrier tube is a metallic tube, such as a tube made of a steel alloy (e.g. a stainless steel).

Preferably, the carrier tube is made of a non-magnetic material, preferably a non-magnetic steel alloy (e.g. a non-magnetic stainless steel).

When the material of the carrier tube is a non-magnetic steel alloy, the iron content of the sputtering material is preferably no more than 5 ppm, more preferably no more than 1 ppm higher than the iron content of the metal coating, measured at a minimal distance of 1 mm from the carrier tube or from a bonding layer, which may optionally be arranged between the metal coating and the carrier tube.

The length of the carrier tube can be e.g. at least 500 mm, or at least 1000 mm, or even at least 1500 mm. The carrier tube can have a maximum length of e.g. 4000 mm.

Accordingly, the sputtering target prepared by the process of the present invention can have a length of e.g. at least 500 mm or at least 1000 mm or at least 1500 mm. The tubular article may have a length of e.g. up to 4000 mm.

Preferably, the carrier tube comprises at least one bonding layer (i.e. an adhesion-promoting layer, a layer for improving adhesion of the metal coating to the carrier tube). Accordingly, if present, the bonding layer represents the outermost layer of the carrier tube and is in contact with the metal coating generated in step (b). In other words, if present, the bonding layer represents the outer surface of the carrier tube. In general, bonding layers for promoting adhesion of a metal coating to a support material are known to the skilled person. Typically, the bonding layer is a metal layer, such as a nickel-containing metal layer (e.g. containing at least 30 wt% or at least 35 wt% nickel) or a copper-containing metal layer (e.g. containing at least 30 wt% or at least 35 wt% copper). Bonding layers which are preferred in the process of the present invention can be made of nickel titanium alloys such as NiTi, nickel aluminium alloys such as NiAl, or a bronze alloy, or mixtures of at least two of these materials.

Bonding layers can be applied on a carrier tube by methods commonly known to the skilled person, such as spray technology (e.g. arc wire, cold gas) and galvanization. As an alternative to the presence of a bonding layer, the outer surface of the carrier tube can be subjected to a surface-roughening, e.g. by treatment with an abrasive medium (such as abrasive paper). Just like a bonding layer, surface-roughening is also promoting adhesion of the metal coating applied in step (b) to the carrier tube. Alternatively, it is also possible that the carrier tube comprises a bonding layer (typically forming the outer surface of the carrier tube), and said bonding layer is subjected to a surface-roughening treatment.

Preferably, the outer surface of the carrier tube (e.g. the bonding layer) has a surface roughness Ra of from 50-500 $\mu$m.

In step (b) of the process of the present invention, a metal coating (e.g. a sputter material) is provided on the carrier tube by applying a liquid metal phase onto the carrier tube by spraying and solidifying the liquid metal phase. Methods for applying a liquid metal phase onto a carrier material and, upon solidification of the liquid metal phase, providing a metal coating on said carrier material are generally known to the skilled person.

The liquid metal phase can be prepared by various thermal spay methods or by direct spraying from a metal melt. As will be discussed below in further detail, it can be preferred that the liquid metal phase being applied onto the carrier tube is in the form of droplets (e.g. by spray coating).

Preferably, the carrier tube rotates around its tube axis while applying the liquid metal phase onto the carrier tube. Coating methods which can be used for applying a liquid metal phase onto a carrier tube are spraying, melt dipping (i.e. dipping the carrier tube into the metal melt), pouring a metal melt on the carrier tube which preferably rotates during the pouring step, or fixing a metal wire or strip on the carrier tube and melting the metal wire or strip while preferably rotating the carrier tube.

Spraying is a coating method which is commonly known to the skilled person. In a spraying process, molten material is sprayed onto a surface. Spraying can be carried out e.g. by atomizing a metal melt (the "feedstock") with an atomizer gas (preferably an inert gas such as a noble gas or nitrogen), thereby generating a liquid metal phase in the form of droplets which move towards the carrier tube. The "feedstock" can be heated by electrical or chemical means (e.g. combustion flame). An inert gas such as argon, nitrogen or mixtures thereof can be used to cover the melt and avoid oxidation. In parallel the function of the gas is to be the atomizer gas. The atomization or aerosol formation of the liquid melt can be achieved e.g. by a nozzle characterized by two rings; preferably two concentric rings wherein the metal melt is fed into the inner ring (e.g. by hydrostatic pressure) and the atomizer gas is fed into the outer ring. The atomizer gas may be heated in order to avoid untimely cooling of the melt droplets. The atomizer gas is directed to the stream of molten metal. Therefore the molten metal is atomized and the aerosol containing molten droplets of metal is directed to the surface of the carrier tube. When the molten droplets hit the carrier tube surface, they start to solidify.

Other spraying methods that can be used in the process of the present invention for providing the metal coating on the carrier tube are e.g. wire arc spraying, high velocity oxy-fuel coating spraying ("HVOF"), flame spraying. Appropriate process conditions for these spraying methods are known to the skilled person or can be established by routine experimentation. Preferably, the carrier tube rotates around its tube axis while spraying the liquid metal phase onto the carrier tube.

When providing the metal coating by melt dipping (not according to the present invention), the carrier tube is dipped into a metal melt. The carrier tube which has been removed from the metal melt is preferably rotating so as to homogeneously distribute the liquid metal phase over the carrier tube. While the tube is rotating the thin metal film solidifies. After solidification, the carrier tube can be dipped again into the metal melt, so as to be coated again. Solidification speed is controlling the thickness of the layer and the rotation speed. After certain rotations and creation of certain layers on the backing tube a target with a certain thickness is achieved on the backing tube. Inner cooling of the backing tube supports the solidification.

Preferably, a continuous (i.e. a non-segmented) metal coating is provided in step (b). A non-segmented metal coating is a metal coating which is not interrupted by a gap. Depending on the final application the tubular article shall be used for, thickness of the metal coating provided in step (b) may vary over a broad range. The metal coating may have a thickness of from 1 mm to 25 mm.

Preferably, the metal used for preparing the coating of step (b) is a metal which is plastically deformable at room temperature (i.e. at 20°C). Preferably, the metal is a ductile metal. Such metals are particularly suitable for the densification treatment carried out in step (c). Based on his common general knowledge, the skilled person knows or can determine by routine experiments whether or not a metal is plastically deformable at room temperature and what pressure is needed for initiating plastic deformation. In the present invention, the term "metal" encompasses metals containing just one metallic element and unavoidable metallic impurities as well as alloys and intermetallic compounds of two or more metallic elements and unavoidable metallic impurities.

Preferred metallic elements are e.g. In, Zn, Sn, and Pb. As mentioned above, the metal may contain just one metallic element and optionally unavoidable metallic impurities, or can be an alloy containing two or more metallic elements and optionally unavoidable impurities.

The metal can be also an alloy. If so, it preferably contains one of the above-mentioned metallic elements (i.e. In, Zn, Sn, or Pb) as a major metallic element, and one or more alloying metallic elements which are preferably selected from In, Zn, Sn, Pb, Cu, Ga, Ag, Sb, Bi, and Al, under the provision that the major metallic element and the one or more alloying elements are different. Preferably, the alloy contains the alloying metallic elements in an amount of 20 wt% or less, more preferably 12 wt% or less, based on the total weight of the alloy.

As an exemplary metal which is an indium-based alloy, the following one can be mentioned: An indium-based alloy containing an alloying metal element such as tin in an amount of from 20 wt% to 5 wt%, more preferably 12 wt% to 7 wt% (e.g. an indium-based alloy containing 10 wt% Sn), based on the total weight of the alloy. However, alloys containing either higher or lower amounts of one or more alloying elements can be used in the present invention as well.

Preferably, the metal contains the unavoidable metallic impurities in an amount of less than 0.01 wt% or even less than 0.001 wt%.

The amount of alloying metallic elements can be determined e.g. by ICP (Inductively Coupled Plasma method).

Preferably, the metal has a purity of at least 99.99%, more preferably at least 99.999%.

Step (c) of the process of the present invention comprises applying a contact pressure to the metal coating by at least one densification tool, and moving the densification tool and the metal coating relative to each other.

Preferably, the contact pressure applied by the densification tool in step (c) is high enough for increasing the relative density (and thereby decreasing porosity) of the metal coating of step (b). Preferably, the contact pressure is high enough for initiating plastic deformation of the metal coating. In other words, the contact pressure which is applied to the metal coating at the process temperature is preferably above the yield point of the metal which forms the coating. As known to the skilled person, yield point of a material is defined as the stress at which a material begins to deform plastically. Depending on the metal used for preparing the coating, the contact pressure applied to the metal coating may vary over a broad range. The contact pressure can be within the range of from e.g. 0.1 MPa to 50 MPa or 0.1 MPa to 15 MPa. However, a contact pressure below or above these ranges might be used as well.

The contact pressure applied to the metal coating during step (c) might be constant or may vary. According to the invention, the contact pressure is increased during step (c). The contact pressure can be increased gradually or step wise. For applying a high contact pressure (i.e. a high compressive force per unit area), it can be preferred that the contact area between the densification tool and the metal coating is relatively small if compared to the total area of the metal coating.

The relative movement between the metal coating and the densification tool can be accomplished by rotation (such as rotation of the carrier tube around its tube axis), and/or by relative movement in longitudinal direction (such as movement along the axis of the carrier tube). According to the invention, the relative movement between the metal coating and the densification tool is such that the path of the densification tool over the metal coating is spiral. There are different ways how such a spiral path of the densification tool over the metal coating can be achieved. Just as an example, the carrier tube may rotate around its tube axis and additionally be moved along its tube axis (i.e. in longitudinal direction), while the densification tool (e.g. rolling or forging tools) applies a contact pressure (either continuously or temporarily) to the metal coating. However, it is also possible that the densification tool is moved in longitudinal direction, while the carrier tube is only rotating around its tube axis. After a spiral path over the length of the carrier tube has been completed, the movement of the carrier tube along its tube axis can be reversed, thereby starting a further spiral path, but in reverse direction. The spiral path of the densification tool over the metal coating can be repeated at least once. Two consecutive spiral paths of the densification tool over the metal coating can have the same orientation (e.g. both being a left-handed or right-handed spiral path) or may have opposite orientations (e.g. a left-handed spiral path followed by a right-handed spiral path, or *vice versa*).

Due to the relative movement, the densification tool comes into contact and densifies a large area of the metal coating during step (c), even if the contact area between the metal coating and the densification tool at a specific point in time is relatively small compared to the total area of the metal coating. This can be influenced e.g. by the shape of the densification tool (such as rolls which can be e.g. conically shaped like pilger rolls).

For rotating around its axis and/or moving along its axis in longitudinal direction, the carrier tube is preferably fixed (e.g. at one end or at both ends) in a device which preferably includes a driving unit for initiating rotation and/or movement in longitudinal direction.

Depending on how fast the carrier tube is moved in longitudinal direction, or how distant the longitudinal replacement of the displacement tool was chosen, neighbouring traces of the path performed by the densification tool over the carrier tube surface may or may not overlap. The pattern on the surface of the tube can be spiral or helical. For improving efficiency of the densification step, it can be preferred that the carrier tube is moved in longitudinal direction at such a speed that neighbouring pitches are overlapping. The overlap can be e.g. 1 to 90%, more preferably 2 to 60%, or 3 to 30%, or 5 to 20% of the width of a single trace.

As will be discussed below in further detail, the contact pressure is preferably applied to the metal coating by rolling (e.g. skew rolling, pilger step rolling, cross rolling), forging, swaging (e.g. rotary swaging), or a combination of at least two of these methods.

The densification tool can be in permanent contact with the metal coating during step (c). Alternatively, it is possible that the densification tool contacts the metal coating only temporarily (e.g. in pre-defined time intervals) during step (c).

The temperature at which step (c) is carried out can vary over a broad range. Step (c) is typically carried out at a temperature of from 10°C to ($T_{solidus}$-50°C), wherein $T_{solidus}$ is the solidus temperature of the metal or alloy. The process temperature of step (c) can be e.g. from 10°C to 300°C or 20°C to 200°C.

The process temperature of step (c) can be at least temporarily above the recrystallisation temperature of the metal ("hot working"). Alternatively, it is also possible that the process temperature of step (c) is consistently below the recrystallisation temperature of the metal ("cold working").

Preferably, the inner diameter of the carrier tube remains substantially constant during step (c). "Substantially constant" means that the inner diameter of the carrier tube remains constant or changes by less than 5%, more preferably less than 2% during step (c). Preferably, the carrier tube is made of a rigid material so as to keep the diameter of the carrier tube substantially constant during step (c). Appropriate materials for the carrier tube have already been mentioned above. In principle, it is also possible that a rod is inserted into the hollow inner part of the carrier tube so as to avoid any substantial changes of the diameter of the carrier tube during step (c). Preferably, in the hollow inner part of the carrier tube, there is no densification tool such as a rolling or forging tool positioned which may apply a contact pressure to the inner surface of the carrier tube.

Densification tools which are suitable for applying a compressive force to a metal coating are generally known to the skilled person. Exemplary densification tools are rolling tools and forging tools.

Preferred densification tools are one or more rolls, one or more hammers, one or more dies, or combinations thereof.

Accordingly, in a preferred embodiment, step (c) comprises a rolling, forging, swaging, or a combination of at least two of these methods. Preferably, the at least one densification tool is a rolling tool, a forging tool, or a swaging tool, and said at least one densification tool and the metal coating are moved relative to each other by rolling, forging or swaging or a combination of at least two of these methods.

Rolls that can be used for rolling metals are commonly known to the skilled person. The roll can be at least partially in the form of a cylinder, a cone, a truncated cone, a double-cone, or a double truncated cone, or any combination of at least two of these forms. The roll can be e.g. a skew roll or a pilger roll. However, other roll geometries can be used as well.

When using one or more rolls as densification tools, the rolling can be carried out as commonly known to the skilled person. The rolling can be e.g. a skew rolling, a pilger rolling (also known as pilger step rolling), a cross rolling, or a combination of at least two of these rolling methods.

When using one or more rolls, the contact pressure can be applied by pressing the roll(s) against the metal coating, and rotating the carrier tube around its tube axis. Due to the rotation of the carrier tube, the one or more rolls will rotate as well, and there is a relative movement (by rotation) between the metal coating and each of the rolls. Additionally, it can be preferred that there is also a relative movement between the metal coating and the roll in longitudinal direction, e.g. by moving the rotating carrier tube along its tube axis while keeping the rotating rolls in a fixed position. When the carrier tube rotates around its tube axis and additionally moves in longitudinal direction along its tube axis, the path of the roll over the metal coating is spiral. The spiral path of the roll over the metal coating can be repeated at least once. Two consecutive spiral paths of the roll over the metal coating can have the same orientation (e.g. both being a left-handed or right-handed spiral path) or may have opposite orientations (e.g. a left-handed spiral path movement followed by a right-handed spiral path, or *vice versa*).

Preferably, the contact pressure between the roll and the metal coating is above the yield point of the metal coating so as to initiate plastic deformation of the metal coating.

Preferably, the orientation of the cylindrical axis of the roll is substantially parallel to the tube axis. "Substantially parallel" means either parallel or a deviation from parallel orientation of less than ±10°, more preferably less than ±2°.

In the process of the present invention, it is also possible that the cylindrical axis of the roll is inclined to the tube axis , e.g. by an inclination angle of from 5° to 25°. Typically, the axis length of the roll is less than the length of the carrier tube. The ratio of the length of the roll axis to the length of the carrier tube axis can be e.g. less than 0.9, more preferably less than 0.5 or less than 0.05 or even less than 0.005.

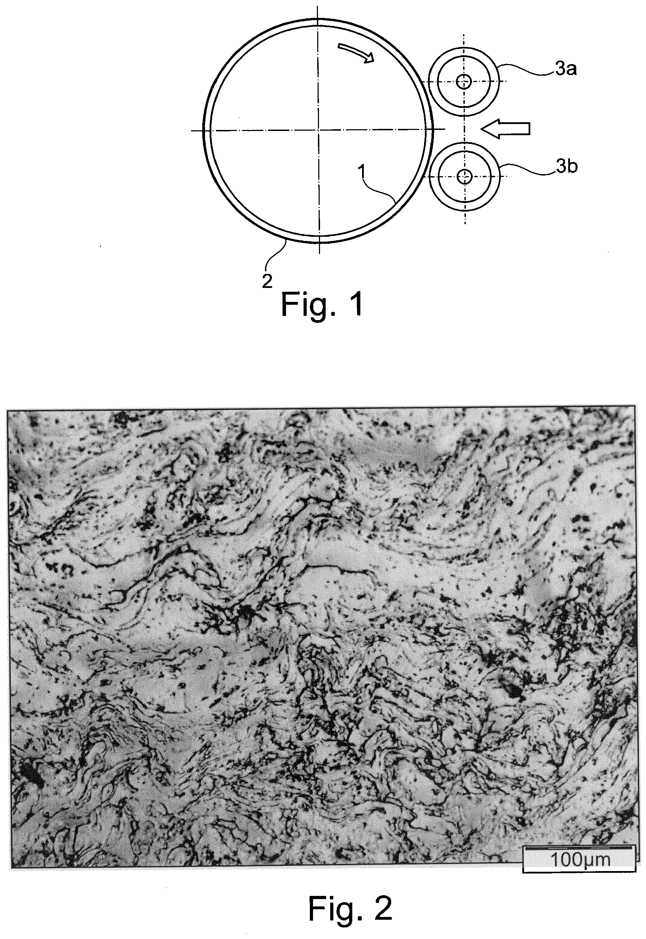

In principle, it is sufficient to use one roll which passes over the metal coating (e.g. in a spiral or helical path). Preferably, at least two rolls are used. If two or more rolls are used, the location of these rolls relative to each other is not critical. Just as an example, a pair of rolls can be located relative to each other on opposite sides of the carrier tube. Alternatively, a pair of rolls might be located relative to each other as shown in Figure 1.

An exemplary arrangement of two rolls 3a and 3b which are pressed against the metal coating 2 provided on a carrier tube 1 is shown in Figure 1. The carrier tube 1 rotates clockwise around its tube axis, thereby initiating a counter-clockwise rotation of the rolls 3a and 3b. The axis length of the rolls 3a and 3b is less than the length of the carrier tube 1. For making sure that the entire surface of the metal coating 2 is subjected to a densification treatment, the carrier tube 1 is not only rotated around its tube axis but additionally moved along its tube axis (i.e. in longitudinal direction). Accordingly, the path of each of the rolls 3a and 3b over the metal coating 2 is a spiral path.

When using one or more forging tools for applying a contact pressure to the metal coating, these forging tools are contacting the metal wall in pre-defined time intervals (e.g. by moving the forging tool up and down or forwards and backwards), while preferably rotating the carrier tube around its tube axis and/or moving the carrier tube in longitudinal direction along its tube axis. When the forging tool hits the metal coating, a contact pressure is applied to the metal coating which is preferably above the yield point of the metal coating.

When using a swaging for applying a contact pressure to the metal coating, it can be e.g. a rotary swaging. As known to the skilled person, at least two dies (e.g. sets of two, three, four or six dies) perform small, high-frequency, simultaneous radial movements (oscillations). With the strokes of the die, the metal coating is densified. Die movement can be generated by means of cams. The kinematics are e.g. equivalent to those of a planetary gear. This is completely accessible, which makes it easy to carry out any maintenance work.

Preferably, step (c) does not comprise isostatic pressing, such a cold isostatic pressing (CIP) or hot isostatic pressing (HIP).

Preferably, step (c) is carried out for a period of time which is sufficient for increasing the relative density of the metal coating to at least 90%, more preferably at least 95%.

In principle, step (c) may start after having finished step (b).

Alternatively, step (c) can start while step (b) is still carried out, e.g. by providing the metal coating on a first part of the carrier tube, followed by applying the contact pressure to the metal coating of the first part while simultaneously providing a metal coating on a second part of the carrier tube. If step (c) and step (b) overlap in time, the densification treatment can be carried out on a metal coating which has just been solidified and is still above room temperature, therefore typically requiring a lower contact pressure for increasing density (and reducing porosity) of the metal coating.

The thickness of the metal coating obtained after the densification treatment of step (c) may vary over a broad range. The metal coating may have a thickness of e.g. from 1 mm to 25 mm.

After step (c), one or more post-treatment steps can be carried out, such as a surface smoothing treatment (e.g. by turning).

Alternatively, after step (c), step (b) can be repeated, followed by a further step (c). When repeating step (b), the metal used for preparing the coating can be the same as used before, or may be different.

Preferably, the process of the present invention does not comprise an isostatic pressing step such as cold isostatic pressing (CIP) or hot isostatic pressing (HIP).

According to a further aspect, the present invention provides a tubular sputtering target according to claim 11 which comprises a carrier tube and at least one metal coating on the carrier tube, and which is obtainable by the process of the present invention.

Preferably, the tubular article has a length of at least 500 mm, more preferably at least 1000 mm. The tubular article can have a maximum length of up to 4000 mm. Preferably, the carrier tube comprises a continuous, non-segmented metal coating over a length of at least 500 mm, more preferably at least 1000 mm.

Preferably, the metal coating has a relative density of at least 90%, more preferably at least 95%, even more preferably at least 97% after densification.

Preferably, the metal coating is continuous, i.e. non-segemented, no gap in circumferential direction by which two neighbouring coating segments are separated. With regard to the preferred properties of the carrier tube and the metal coating, reference is made to the description of the process of the present invention provided above. The metal coating has a mean grain size of 500 μm or less, preferably of from 10 μm to 500 μm.

Preferably, the metal coating has a porosity of less than 10%, more preferably less than 6%.

Preferably, the metal coating has an average pore diameter of less than 50 μm. The metal coating does not contain pores having a diameter of at least 50 $\mu$m. In other words, if pores are present in the metal coating, they exclusively have pore diameters of less than 50 $\mu$m.

Preferably, the metal coating contains more than one pore per $cm^3$.

Preferably, the metal coating has a roughness Ra of from 1.5 to 3.0 $\mu$m and Rz of from 7 to 14 $\mu$m. If the tubular article comprises two or more metal coatings, these Ra and Rz values are preferably those of the outermost metal coating.

Preferably, the relative intensities of the four most intensive X-ray diffraction peaks of the metal coating deviate by less than 20%, more preferably less than 15% from the relative intensities of the corresponding X-ray diffraction peaks of a randomly orientated reference material of the same metal.

The relative peak intensities of a specific reference material such as indium, tin, zinc or lead with random orientation can be obtained from commonly accessible powder diffraction file database.

It is commonly known to the skilled person that the texture/preferred crystal orientation of a metal (or any other material) can be analysed by comparing the relative intensities of its X-ray diffraction peaks to the relative intensities of the corresponding peaks of a reference sample of the same metal having random orientation.

Relative intensities of X-ray diffraction peaks are very sensitive to texture modifications. Typically, if metals are subjected to a metal-forming treatment such as rolling or forging, the grains are not randomly oriented but have a specific crystal orientation which is favoured over other orientations. This would be reflected by a significant change of relative intensities of the X-ray diffraction peaks, if compared to a reference sample of the same metal having a random orientation.

In terms of uniform sputtering properties, it can be preferred that the sputtering metal has no specific orientation which dominates over other orientations but rather is as close as possible to a random orientation.

In step (c) of the process of the present invention, a contact pressure is applied to a metal coating by a densification tool such as a roll or a forging tool. However, very surprisingly, the densified metal coating prepared in step (c) still has a grain structure of high randomness, as demonstrated by the X-ray diffraction data.

Preferably, the metal coating comprises grains which are passivated by an oxide layer. The oxide layer is present on the grain surface.

Preferably, the metal coating has an oxygen content of from 10 to 500 ppm, more preferably 30 to 300 ppm, based on the total amount of the metal coating.

Preferably, the tubular article contains a bonding layer between the carrier tube and the metal coating. With regard to preferred properties of the bonding layer, reference is made to the description of the process of the present invention provided above. The tubular article is a sputtering target.

According to a further aspect, the present invention relates to the use of the tubular article described above for manufacturing photovoltaic absorber films.

According to a further aspect, the present invention relates to the use of the tubular article described above for manufacturing oxide films (e.g. on glass substrates) by reactive sputtering.

**Examples**

**I. Measuring methods**

Unless indicated otherwise, the parameters of the present invention have been determined by the following measuring methods:

**Pore diameter**

Pore diameter was determined on a microsection which was prepared as follows: Sample was vacuum-embedded in a polymer matrix and polished with grinding papers of increasing fineness, finally polished with a 4000 SiC paper. Measuring via line intercept method (DIN EN ISO 643), the mean pore diameter was determined according to the following equation:

$$M=(L*p)/(N*m)$$

wherein

L is the length of the measuring line,
p is the number of measuring lines
N is the number of intersected pores,
m is the magnification

**Number of pores per volume**

is determined via image-based analysis. Microsections have been taken and the number of pores on each microsection is determined. From 2D to 3D is concluded by taking average values of 30 microsections while grinding approx. 50-100$\mu$m stepwise into the depth of the material.

**Relative Density**

$$\text{Relative density(\%)} = \text{(geometric density/theoretical density) x 100}$$

$$\text{Geometric density} = \text{mass/volume (geometric)}$$

The mass of a sample is determined by weighing. The dimensions of the sample are measured with a calliper (accuracy: 0.2 mm) and the volume is calculated from the measured dimensions. Average value of three measurements is taken as the geometric density.

Theoretical density values are taken from tables of standard text books.

**Porosity**

$$\text{Porosity(\%)} = 100 - [\text{(geometric density/theoretical density)} \times 100] = 100 - \text{relative density(\%)}$$

**Mean grain size**

Grain size was determined on a microsection which was prepared as follows: Sample was vacuum-embedded in a polymer matrix and polished with grinding papers of increasing fineness, finally polished with a 4000 SiC paper. Measuring via line intercept method (DIN EN ISO 643). The mean grain size was determined according to the following equation:

$$M = (L*p)/(N*m)$$

wherein

L is the length of the measuring line,
p is the number of measuring lines
N is the number of intersected grains,
m is the magnification

**Surface roughness**

Surface roughness has been measured with the optical profilometer New View 7300 of ZYGO. The measurement is based on white light interferometry and is carried out contact-free on 3D surfaces. The measuring and evaluation software Mx™ has been used and provides a statistical error of +/- 20% of the measured values. The arithmetical average of measurements at three different locations (one measurement per location) is taken as the surface roughness.

**Oxygen content**

The oxygen content was determined by carrier gas hot extraction using the TC 436 apparatus from Leco. Oxygen content was determined indirectly by converting the oxygen into $CO_2$ and capturing the $CO_2$ in an IR measuring cell. The method is based on the ASTM E1019-03 norm. The apparatus was calibrated using a known quantity of $CO_2$. The calibration was checked by measuring the oxygen content of a certified steel standard with a known oxygen content which was approximately equal to the oxygen content expected for the sample. The sample was prepared by weighing 100-150 mg of the material into a tin capsule. The probe was introduced at 2000°C, together with the tin capsule, into a graphite crucible, which had been degassed for about 30 seconds at 2500°C. The oxygen of the sample reacted with the carbon of the graphite crucible to yield carbon monoxide (CO). The carbon monoxide was then oxidized to $CO_2$ in a copper oxide column. The column was held at a temperature of 600°C. The $CO_2$ generated in this manner was then detected using an infra-red cell, and the oxygen content was determined. Before the sample was measured, a reference value was determined for an unfilled tin capsule under the same conditions. This reference value was automatically subtracted from the value determined for the sample (metal sample plus tin capsule).

**X-ray diffraction**

X-ray diffraction measurements were made on the two circle goniometer Stadi P from Stoe using Bragg-Brentano geometry. Measured with CuKα1 radiation, 2θ range of from 10° to 105°, step width: 0.03°2 θ.
The measurements were made on 10 mm * 10 mm * 8 mm samples, separated from the metal coating by a cutter.
In the measured diffractogram, relative intensity of an X-ray diffraction peak is determined as follows:
Ratio of the intensity (taken as peak height) of said peak to the intensity of standard values of hkl planes , multiplied by 100.
For each of the 4 most intensive diffraction peaks in the measured diffractogram, the relative intensity was compared with the relative intensity of the corresponding diffraction peak of the randomly orientated reference.
As already mentioned above, X-ray diffraction data can be taken from a commonly accessible powder diffraction file database.

**II. Preparation of tubular sputtering targets**

**Example 1: Preparation of a tubular sputtering target containing an Indium coating**

Providing an Indium coating on a carrier tube

Highly pure indium (99.999%) was melted in a crucible (electrically heated). A carrier tube (stainless steel, outer diameter: 133 mm, length: 3800 mm) provided with a rough adhesion-promoting layer NiTi was mounted on a rotary device. The melted indium metal, i.e. the liquid metal phase, was supplied by a feed line to an atomizer nozzle where it was sprayed by the action of a gas. The liquid drops hit the rotating carrier tube and solidify, and a relative motion of the carrier tube versus the spray nozzle caused a thick (9 mm) metallic indium layer, i.e. the metal coating, to be deposited in the form of multiple layers on the carrier tube over time. A non-segmented metal coating was obtained (i.e. no gaps in circumferential direction). The density of the metal coating was about 80% of the theoretical density. The metal coating had a porosity of about 20%.

Densifying the metal coating by applying a contact pressure with a densification tool

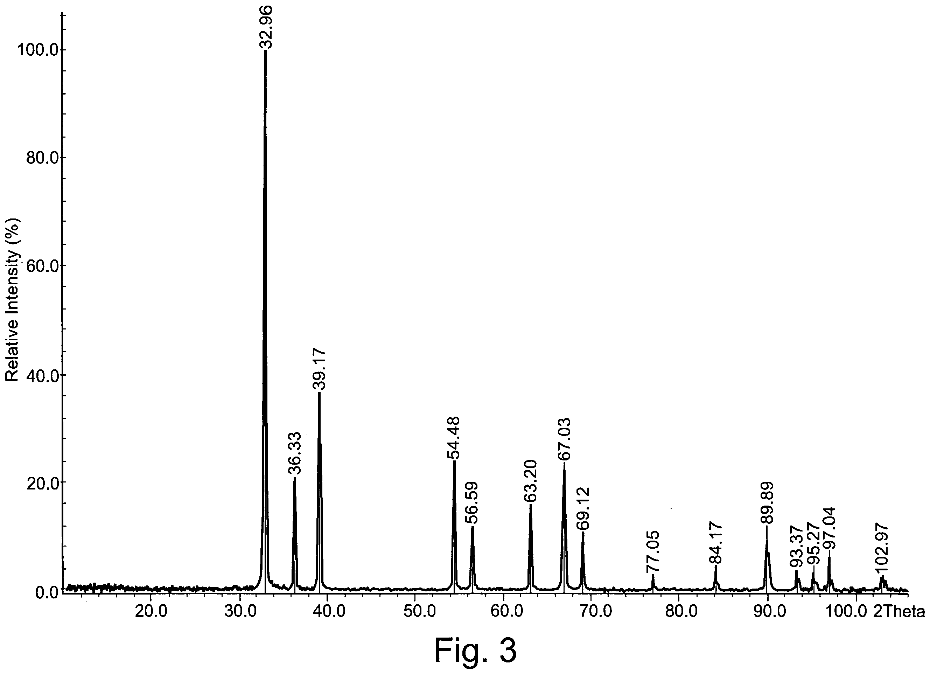

As shown in Figure 1, two rolls were pressed against the rotating carrier tube. The rolls were acting as densification tools. Each roll had a diameter of 80 mm, and a length of 50 mm. In the beginning of the densification step, a contact pressure of about 0.7 MPa was applied by each of the rolls to the metal coating. This contact pressure was above the yield point of the indium coating and therefore sufficient for plastically deforming the indium coating. Due to the plastic deformation, thickness of the metal coating was reduced during step (c). As a consequence thereof, porosity of the metal coating was reduced, while density of the metal coating was increased during step (c). For making sure that the metal coating is still plastically deformed while its density is increasing, the contact pressure applied by the rolls was increased during step (c) from 0.7 MPa to a maximum value of 1.5 MPa.
In addition to the rotation about its tube axis, the carrier tube was also moved along its tube axis. Both the rotation and the movement along the tube axis contributed to the overall relative movement between the rolls and the metal coating. Accordingly, the path of each roll over the metal coating was a spiral path. The rotating carrier tube was moved along its tube axis back and forth five times. Accordingly, there were several repetitions of the spiral path of the densification tools over the metal coating, and a densified metal coating having a porosity of 4% was obtained. The density of the metal coating increased from 80% to 96% of its theoretical density. The densified metal coating did not contain pores with a diameter of more than 50 μm. A micrograph of the metal coating (magnification factor: 200) is shown in Figure 2.
The densified metal coating was subjected to an X-ray diffraction measurement. The X-ray diffractogram is shown in Figure 3. The relative intensities of the 4 most intensive diffraction peaks are shown below in Table 1. Also listed in Table 1 are the relative intensities of the same X-ray peaks of a reference indium sample with random grain orientation.

Table 1:Relative intensities of diffraction peaks

| Peak | 2θ Value | Indium coating of Example 1 Relative Intensity | Reference indium with random orientation Relative Intensity | Deviation from the relative intensity of reference material |
|---|---|---|---|---|
| 101 | 32.97 | 100,0 | 100,0 | 0% |
| 110 | 39.17 | 36.0 | 37.2 | 3.3% |
| 112 | 54.48 | 24.0 | 21.5 | 10.4% |
| 211 | 67.03 | 23.0 | 20.1 | 12.6% |

As already mentioned above, relative intensities of X-ray diffraction peaks are very sensitive to texture modifications. Typically, if metals are subjected to a metal-forming treatment such as rolling or forging, the grain lattice planes are not randomly distributed but have a specific orientation which is favoured over other orientations. This would be reflected by a significant change of relative intensities of the X-ray diffraction peaks, if compared to a reference sample of the same metal having a random orientation. In step (c) of the process of the present invention, a contact pressure is applied to a metal coating by rolls. However, very surprisingly, the densified metal coating prepared in step (c) still has a grain structure of high randomness, as demonstrated by the X-ray diffraction data.

**Example 2: Preparation of a tubular sputtering target containing a tin coating**

a) Providing a tin coating on a carrier tube by melt spraying

Highly pure tin (purity: 99.9%) was melted in a crucible. Following the procedure as described in Example 1, a tin coating was provided on the carrier tube by spraying. A non-segmented tin coating was obtained (i.e. no gap in circumferential direction). The density of the metal coating was about 75% of the theoretical density. The metal coating had a porosity of about 25%.

b) Providing a tin coating on a carrier tube by wire arc spraying

Wire arc spraying is done with Sn on a SST tube, coated with 100μm AlTi bond coat. The Sn wire, 99,8% puritiy is sprayed by Smart Arc Oerlikon Metco with 15 kg/h; 300 Ampere. After reaching 10 mm Sn layer thickness, the density of said Sn layer was about 85% of the theoretical density. Accordingly, the Sn layer had a porosity of about 15%.

Densifying the metal coating by applying a contact pressure with a densification tool

Following the procedure as described in Example 1, the sprayed tin coating was subjected to a densification treatment by rolling.

In the beginning of the densification step, a contact pressure of about 3.8 MPa was applied by each of the rolls to the metal coating. For making sure that the metal coating is still plastically deformed while its density is increasing, the contact pressure applied by the rolls was increased during step (c) to a maximum value of 8 MPa.

After 10 repetitions of the spiral path of the densification tools over the metal coating, a densified metal coating having a porosity of 5% for 2a and 6% for 2b was obtained. The density of the metal coating was 95% of its theoretical density in case of 2a and 94% in case of 2b. The densified metal coating did not contain pores with a diameter of more than 50 μm in both cases.

**Example 3: Preparation of a tubular sputtering target containing a lead (Pb) coating**

Providing a lead coating on a carrier tube

Highly pure Pb was melted in a crucible. Following the procedure as described in Example 1, a lead coating was provided on the carrier tube by spraying. A non-segmented tin coating was obtained (i.e. no seams in circumferential direction). The density of the metal coating was about 75% of the theoretical density. The metal coating had a porosity of about 25%.

<u>Densifying the metal coating by applying a contact pressure with a densification tool</u>

Following the procedure as described in Example 1, the sprayed lead coating was subjected to a densification treatment by rolling.

In the beginning of the densification step, a contact pressure of about 4 MPa was applied by each of the rolls to the metal coating. For making sure that the metal coating is still plastically deformed while its density is increasing, the contact pressure applied by the rolls was increased during step (c) to a maximum value of 8 MPa.

After 10 repetitions of the spiral path of the densification tools over the metal coating, a densified metal coating having a porosity of 5% was obtained. The density of the metal coating was 95% of its theoretical density. The densified metal coating did not contain pores with a diameter of more than 50 $\mu$m.

**Example 4: Preparation of a tubular sputtering target containing an indium-tin coating**

<u>Providing an indium-tin coating on a carrier tube</u>

An indium-tin alloy (90 wt% In, 10 wt% Sn) was melted in a crucible. Following the procedure as described in Example 1, an indium-tin coating was provided on the carrier tube by spraying. A non-segmented indium-tin coating was obtained (i.e. no seams in circumferential direction). The density of the metal coating was about 80% of the theoretical density. The metal coating had a porosity of about 20%.

<u>Densifying the metal coating by applying a contact pressure with a densification tool</u>

Following the procedure as described in Example 1, the sprayed indium-tin coating was subjected to a densification treatment by rolling.

In the beginning of the densification step, a contact pressure of about 3.5 MPa was applied by each of the rolls to the metal coating. For making sure that the metal coating is still plastically deformed while its density is increasing, the contact pressure applied by the rolls was increased during step (c) to a maximum value of 8 MPa.

After 10 repetitions of the spiral path of the densification tools over the metal coating, a densified metal coating having a porosity of 5% was obtained. The density of the metal coating was 95% of its theoretical density. The densified metal coating did not contain pores with a diameter of more than 50 $\mu$m.

**Comparative Example 1: Preparation of a tubular sputtering target containing an indium coating, no treatment with a densification tool**

Highly pure indium (99.999%) was melted in a crucible. A carrier tube provided with a rough adhesion-promoting layer was mounted on a rotary device. The melted indium metal, i.e. the liquid metal phase, was supplied by a feed line to an atomizer nozzle where it was sprayed by the action of a gas. The liquid drops hit the rotating carrier tube and solidify, and a relative motion of the carrier tube versus the spray nozzle caused a metallic indium layer, i.e. the metal coating, to be deposited in the form of multiple layers on the carrier tube over time. A non-segmented metal coating was obtained (i.e. no gap in circumferential direction). The density of the metal coating was about 80% of the theoretical density. The metal coating had a porosity of about 20%.

**Comparative Example 2: Preparation of a tubular sputtering target containing an indium coating, densification treatment by isostatic pressing**

<u>Providing an indium coating on a carrier tube</u>

Highly pure indium (99.999%) was melted in a crucible. A carrier tube provided with a rough adhesion-promoting layer was mounted on a rotary device. The melted indium metal, i.e. the liquid metal phase, was supplied by a feed line to an atomizer nozzle where it was sprayed by the action of a gas. The liquid drops hit the rotating carrier tube and solidify, and a relative motion of the carrier tube versus the spray nozzle caused a thick metallic indium layer, i.e. the metal coating, to be deposited in the form of multiple layers on the carrier tube over time. A non-segmented metal coating was obtained (i.e. no gap in circumferential direction). The density of the metal coating was about 80% of the theoretical density. The metal coating had a porosity of about 20%.

Densifying the metal coating by applying a contact pressure via cold-isostatic pressing (CIP)

The indium-coated carrier tube was water-tightly put into a CIP mould made of silicone. Pressing was carried out at 500 bar in water.

The density of the metal coating was about 96% of the theoretical density. The metal coating had a porosity of about 4%. However, a so-called "elephant foot" was formed which had to be removed by over-twisting, thereby resulting in an undesired loss of material.

If compared to the densification treatment by using rolls (Inventive Examples), a significantly longer process time and higher energy input were needed for reducing porosity of the sprayed indium coating to a final porosity value of about 4%.

### III. Sputtering tests using the sputtering targets of Example 1 and Comparative Examples 1-2

Using the sputtering targets of Example 1 and Comparative Examples 1-2, indium layers were sputtered onto glass substrates.

For each of these sputtering targets, the maximum power input achievable during the sputtering process was determined. Furthermore, quality of the sputtered indium film (in terms of homogeneity) was evaluated qualitatively.

The maximum power input achievable during the sputtering process was determined as follows:

Starting from 10 kW/m, the power input to a sputtering target having a length of 500 mm was increased step-wise by 0.25 kW per step. At each step, the power input level was maintained constant for one hour. If the critical limit of the power input is passed, the sputtering material (i.e. the indium coating) starts to melt, and there is a sudden increase of the arcing rate by several orders of magnitude. The power input being applied to the sputtering target just before passing the critical limit represents the maximum power input achievable during the sputtering process.

The results of the sputtering tests are summarized in Table 1.

Table 1: Properties of the metal coating (i.e. the sputtering material) and results of the sputtering tests

|  | Sputtering target of Example 1 | Sputtering target of Comparative Example 1 | Sputtering target of Comparative Example 2 |
|---|---|---|---|
| Porosity | 4% | 20% | 4% |
| Relative Density | 96% | 80% | 96% |
| Pores with diameter of at least 50 $\mu$m | No | Yes | No |
| Time needed for preparing the sputtering target | Short | Short | Very long |
| Energy input needed for the densification treatment | Low | Low | Very high |
| Critical power limit during sputtering | 22 kW/m | 15 kW/m | 22 kW/m |
| Arcing (at 10 kW/m) | Low | High | Low |
| Homogeneity of the sputtered indium layers | High | Low | High |

As demonstrated by the examples, the process of the present invention provides non-segmented sputtering targets of sufficient length for large-scale sputtering applications at low process times and low energy input. Furthermore, the sputtering targets obtained from the process of the present invention can be operated at a high power input with low arcing and provides a sputtered product of high homogeneity.

### Claims

1.    A process for preparing a tubular sputtering target, comprising

(a) providing a carrier tube,

(b) providing a metal coating on the carrier tube by applying a liquid metal phase onto the carrier tube by spraying and solidifying the liquid metal phase,

(c) applying a contact pressure to the metal coating by at least one densification tool, and moving the densification tool and the metal coating relative to each other,

wherein the contact pressure is increased during step (c) and
wherein the path of the densification tool over the metal coating is spiral.

2. The process according to claim 1, wherein the carrier tube is made of a steel alloy, which is preferably non-magnetic; and/or wherein the carrier tube has a length of at least 500 mm.

3. The process according to one of the preceding claims, wherein the carrier tube comprises a bonding layer, and/or wherein the outer surface of the carrier tube is subjected to a surface-roughening.

4. The process according to one of the preceding claims, wherein the metal is ductile, and/or the metal is a metal which is plastically deformable at room temperature.

5. The process according to one of the preceding claims, wherein the metal is indium or an alloy thereof, zinc or an alloy thereof, tin or an alloy thereof, lead or an alloy thereof.

6. The process according to one of the preceding claims, wherein the contact pressure is above the yield point of the metal coating.

7. The process according to one of the preceding claims, wherein step (c) comprises a rolling, forging, and/or swaging.

8. The process according to claim 7, wherein the rolling is a skew rolling, a pilger step rolling, a cross rolling, or a combination of at least two of these rolling methods; and/or wherein the swaging is a rotary swaging.

9. The process according to one of the preceding claims, wherein the inner diameter of the carrier tube remains substantially constant during step (c).

10. The process according to one of the preceding claims, wherein step (c) starts after having finished step (b), or wherein step (c) starts while step (b) is still carried out.

11. A tubular sputtering target, which comprises a carrier tube and at least one metal coating on the carrier tube, and which is obtainable by the process according to one of the claims 1 to 10; wherein the metal coating has a mean grain size of 500 $\mu$m or less, and wherein the metal coating has no pores with a diameter of at least 50 $\mu$m.

12. The tubular sputtering target according to claim 11, wherein the metal coating on the carrier tube is continuous, non-segmented over a length of at least 500 mm, more preferably at least 1000 mm in axial direction of the carrier tube, the metal coating preferably having a relative density of at least 90%.

13. The tubular sputtering target according to claim 11 or 12, wherein the relative intensities of the four most intensive X-ray diffraction peaks of the metal coating deviate by less than 20%, more preferably less than 15% from the relative intensities of the corresponding X-ray diffraction peaks of a randomly orientated reference material of the same metal.

**Patentansprüche**

1. Verfahren für die Herstellung eines rohrförmigen Sputter-Targets, umfassend

(a) das Bereitstellen eines Trägerrohrs,

(b) das Bereitstellen einer Metallbeschichtung auf dem Trägerrohr durch Aufbringen einer flüssigen Metallphase auf das Trägerrohr durch Sprühen und Verfestigen der flüssigen Metallphase,

(c) das Aufwenden eines Kontaktdrucks auf die Metallbeschichtung durch mindestens ein Verdichtungswerkzeug und Bewegen des Verdichtungswerkzeugs und der Metallbeschichtung relativ zueinander,

wobei der Kontaktdruck während Schritt (c) erhöht wird und
wobei der Weg des Verdichtungswerkzeugs über die Metallbeschichtung spiralförmig ist.

2.  Verfahren nach Anspruch 1, wobei das Trägerrohr aus einer Stahllegierung hergestellt ist, die bevorzugt nichtmagnetisch ist; und/oder wobei das Trägerrohr eine Länge von mindestens 500 mm aufweist.

3.  Verfahren nach einem der vorhergehenden Ansprüche, wobei das Trägerrohr eine Bondierschicht umfasst und/oder wobei die Außenfläche des Trägerrohrs einer Oberflächenaufrauhung unterworfen wird.

4.  Verfahren nach einem der vorhergehenden Ansprüche, wobei das Metall verformbar ist und/oder das Metall ein Metall ist, das bei Raumtemperatur plastisch verformbar ist.

5.  Verfahren nach einem der vorhergehenden Ansprüche, wobei das Metall Indium oder eine Legierung davon, Zink oder eine Legierung davon, Zinn oder eine Legierung davon, Blei oder eine Legierung davon ist.

6.  Verfahren nach einem der vorhergehenden Ansprüche, wobei der Kontaktdruck über der Streckgrenze der Metallbeschichtung liegt.

7.  Verfahren nach einem der vorhergehenden Ansprüche, wobei der Schritt (c) Walzen, Schmieden und/oder Kaltverformen umfasst.

8.  Verfahren nach Anspruch 7, wobei das Walzen Schrägwalzen, Pilgerschrittwalzen, Kreuzwalzen oder eine Kombination von mindestens zwei dieser Walzverfahren ist; und/oder wobei das Kaltverformen Rotationskaltverformen ist.

9.  Verfahren nach einem der vorhergehenden Ansprüche, wobei der Innendurchmesser des Trägerrohrs während des Schritts (c) im Wesentlichen konstant bleibt.

10. Verfahren nach einem der vorhergehenden Ansprüche, wobei der Schritt (c) beginnt, nachdem der Schritt (b) beendet worden ist, oder wobei der Schritt (c) beginnt, während der Schritt (b) noch ausgeführt wird.

11. Rohrförmiges Sputter-Target, das ein Trägerrohr und mindestens eine Metallbeschichtung auf dem Trägerrohr umfasst und das durch das Verfahren nach einem der Ansprüche 1 bis 10 erhältlich ist; wobei die Metallbeschichtung eine mittlere Korngröße von 500 μm oder weniger aufweist und wobei die Metallbeschichtung keine Poren mit einem Durchmesser von mindestens 50 aufweist.

12. Rohrförmiges Sputter-Target nach Anspruch 11, wobei die Metallbeschichtung auf dem Trägerrohr über eine Länge von mindestens 500 mm, noch bevorzugter mindestens 1000 mm, in axialer Richtung des Trägerrohrs kontinuierlich, nicht segmentiert ist, wobei die Metallbeschichtung bevorzugt eine relative Dichte von mindestens 90 % aufweist.

13. Rohrförmiges Sputter-Target nach Anspruch 11 oder 12, wobei die relativen Intensitäten der vier intensivsten Röntgenstrahlenbeugung-Peaks der Metallbeschichtung weniger als 20 %, noch bevorzugter weniger als 15 % von den relativen Intensitäten der entsprechenden Röntgenstrahlenbeugung-Peaks eines willkürlich orientierten Bezugsmaterials aus demselben Metall abweichen.

**Revendications**

1.  Procédé de préparation d'une cible de métallisation tubulaire, comprenant

    (a) l'utilisation d'un tube support
    (b) l'utilisation d'un revêtement métallique sur le tube support par application d'une phase de métal liquide sur le tube support par pulvérisation et solidification de la phase de métal liquide,
    (c) l'application d'une pression de contact sur le revêtement métallique par au moins un outil de densification, et le déplacement de l'outil de densification et du revêtement métallique l'un par rapport à l'autre,

    dans lequel la pression de contact est augmentée pendant l'étape (c) et
    dans lequel la trajectoire de l'outil de densification sur le revêtement métallique est une spirale.

**2.** Procédé selon la revendication 1, dans lequel le tube support est en alliage d'acier, qui est de préférence non magnétique ; et/ou dans lequel le tube support a une longueur d'au moins 500 mm.

**3.** Procédé selon l'une quelconque des revendications précédentes, dans lequel le tube support comprend une couche liante, et/ou dans lequel la surface extérieure du tube support est soumise à une rugosification de surface.

**4.** Procédé selon l'une quelconque des revendications précédentes, dans lequel le métal est ductile, et/ou le métal est un métal qui est plastiquement déformable à température ambiante.

**5.** Procédé selon l'une quelconque des revendications précédentes, dans lequel le métal est de l'indium ou un alliage de celui-ci, du zinc ou un alliage de celui-ci, de l'étain ou un alliage de celui-ci, du plomb ou un alliage de celui-ci.

**6.** Procédé selon l'une quelconque des revendications précédentes, dans lequel la pression de contact est supérieure à la limite d'élasticité du revêtement métallique.

**7.** Procédé selon l'une quelconque des revendications précédentes, dans lequel l'étape (c) comprend un laminage, un forgeage et/ou une rétreinte.

**8.** Procédé selon la revendication 7, dans lequel le laminage est un laminage en biais, un laminage à pas de pèlerin, un laminage transversal, ou une combinaison d'au moins deux de ces procédés de laminage ; et/ou dans lequel la rétreinte est une rétreinte rotative.

**9.** Procédé selon l'une quelconque des revendications précédentes, dans lequel le diamètre intérieur du tube support reste sensiblement constant pendant l'étape (c).

**10.** Procédé selon l'une quelconque des revendications précédentes, dans lequel l'étape (c) commence après avoir fini l'étape (b), ou dans lequel l'étape (c) commence pendant que l'étape (b) est encore effectuée.

**11.** Cible de métallisation tubulaire, qui comprend un tube support et au moins un revêtement métallique sur le tube support, et qui peut être obtenu par le procédé selon l'une quelconque des revendications 1 à 10 ; dans laquelle le revêtement métallique a une taille de grain moyenne de 500 $\mu$m ou moins, et dans laquelle le revêtement métallique n'a pas de pores ayant un diamètre d'au moins 50 $\mu$m.

**12.** Cible de métallisation tubulaire selon la revendication 11, dans laquelle le revêtement métallique sur le tube support est continu, non segmenté sur une longueur d'au moins 500 mm, plus préférablement d'au moins 1 000 mm dans une direction axiale du tube support, le revêtement métallique ayant de préférence une densité relative d'au moins 90 %.

**13.** Cible de métallisation tubulaire selon la revendication 11 ou 12, dans laquelle les intensités relatives des quatre pics de diffraction des rayons X les plus intenses du revêtement métallique dévient de moins 20 %, plus préférablement de moins de 15% par rapport aux intensités relatives des pics de diffraction des rayons X correspondants d'un matériau de référence orienté de manière aléatoire du même métal.

Fig. 1

Fig. 2

Fig. 3

**EP 3 085 809 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102009015638
- US 20120213917 A
- DE 3618949 A1
- WO 2015004958 A